# FASCICULE DE BREVET EUROPEEN

(11) **EP 1 415 951 B1**
(45) Date de publication et mention de la délivrance du brevet: **09.11.2016**
(21) Numéro de dépôt: 03354080.8
(22) Date de dépôt: 20.10.2003
(51) Int. Cl.: B81C 1/00

(54) **Microstructure électromécanique intégrée comportant des moyens de réglage de la pression dans une cavité scellée et procédé de réglage de la pression**
Integrierte elektromechanische Struktur, die Vorrichtungen enthält, um den Druck zu regeln, und Verfahren zum Regeln des Drucks
Integrated electromechanical microstructure having means for regulating pressure and method for regulating pressure

(30) Priorité: 24.10.2002 FR 0213325
(43) Date de publication de la demande: 06.05.2004
(73) Titulaire: Commissariat à l'Énergie Atomique et aux Énergies Alternatives, 75015 Paris (FR)
(72) Inventeur: Delapierre, Gilles, 38180 Seyssins (FR)
(74) Mandataire: Hecké, Gérard

(56) Documents cités:
- WO-A-98/26443
- WO-A-98/37392
- US-A- 5 610 438
- US-B1- 6 247 485
- R. Casiday, R. Frey: "Gas Laws Save Lives:The Chemistry Behind Airbags", , October 2000 (2000-10), Retrieved from the Internet: URL:http://www.chemistry.wustl.edu/~edudev /LabTutorials/Airbags/airbags.html [retrieved on 2013-11-29]

## Description

### Domaine technique de l'invention

L'invention concerne une microstructure électromécanique intégrée, comportant un substrat de base et une cavité fermée par un capot de protection, ainsi qu'un procédé de réglage de la pression dans la cavité.

### État de la technique

Les microstructures électromécaniques intégrées ou MEMS (« Micro electromechanical systems ») utilisant des procédés de fabrication issus de la microélectronique sont de plus en plus utilisés, notamment pour la fabrication d'accéléromètres, de gyromètres pour la navigation et de commutateurs RF ou optiques pour les télécommunications.

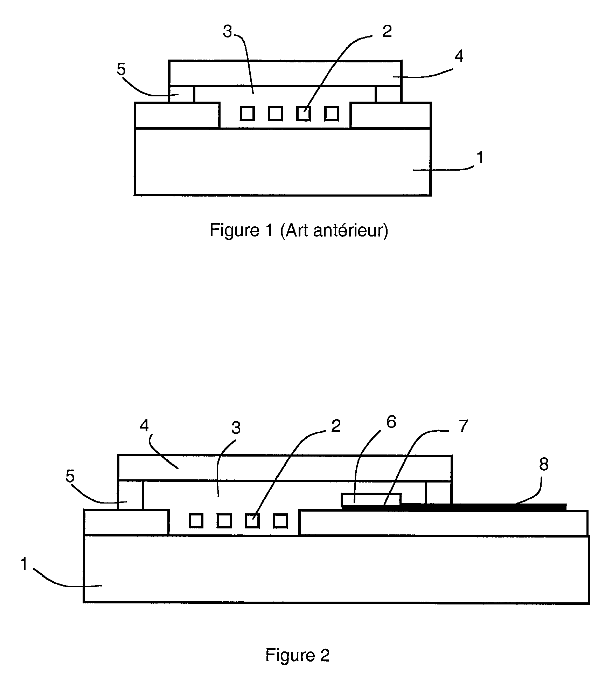

Comme représenté schématiquement à la figure 1, une telle microstructure comporte classiquement un substrat de base 1. Les éléments mécaniques mobiles 2 de la microstructure sont disposés dans une micro-cavité 3. Celle-ci est fermée par un capot de protection 4 au moyen d'un cordon de scellement 5 périphérique. Pour réduire les coûts, plusieurs microstructures sont généralement fabriquées simultanément et un capot de protection commun à toutes les microstructures est scellé avant découpage des différentes microstructures.

Les performances des éléments mécaniques des microstructures, comme le bruit thermique, l'amortissement ou la bande passante, dépendent directement de l'atmosphère gazeuse entourant ces éléments à l'intérieur de la cavité 3. Dans les procédés de fabrication actuels, la pression à l'intérieur de la cavité 3 est fixée par la pression environnante au moment du scellement. L'atmosphère finale à l'intérieur de la cavité est, en effet, liée au procédé de scellement et, lors de la fabrication simultanée de plusieurs microstructures, elle est forcément identique dans toutes les cavités. Par ailleurs, elle est fixée une fois pour toute, dépend de la température de scellement du fait de la loi des gaz parfaits et peut être polluée par le dégazage des matériaux lors du scellement.

Il peut être souhaité de contrôler assez précisément l'atmosphère à l'intérieur de la cavité 3. On peut, par exemple, souhaiter faire le vide dans la cavité pour avoir un bruit faible ou des pics de résonance très pointus, ou avoir une pression de quelques bars pour un fort amortissement et des fréquences de coupure très basses.

Dans certains cas, on utilise un procédé de scellement en deux étapes : après scellement du capot 4, qui est initialement muni d'un trou, la pression est fixée à la valeur souhaitée et le trou est bouché. Ce procédé, relativement complexe, n'est cependant pas totalement satisfaisant

Le brevet US 6 247 485 décrit un dispositif comportant un circuit imprimé et une cavité fermée par une enveloppe gonflable. Le dispositif comporte également une charge pyrotechnique disposée entre le circuit imprimé et la cavité. Un tel dispositif est utilisé pour éjecter un fluide hors d'une poche grâce au gonflement de l'enveloppe provoqué par la combustion de la charge pyrotechnique.

Le brevet US 5 610 438 décrit un dispositif électromécanique encapsulé dans un boîtier et comportant un micro-miroir déformable, une électrode de réception et un getter. Le getter permet, par voie de réaction chimique ou physique, d'absorber l'eau et/ou d'adsorber certains gaz au sein du boîtier.

### Objet de l'invention

L'invention a pour but de surmonter ces inconvénients et, plus particulièrement de faciliter la gestion de la pression dans la cavité d'une microstructure électromécanique intégrée.

Selon l'invention, ce but est atteint par les revendications annexées et plus particulièrement par le fait que la microstructure comporte des moyens de réglage de pression comportant au moins un élément en matériau pyrotechnique dont la combustion libère du gaz dans la cavité, de manière à régler la pression dans la cavité après scellement du capot de protection.

Il est ainsi possible de définir la pression dans la cavité indépendamment du procédé de scellement et de régler individuellement la pression dans chaque composant déjà scellé.

L'élément en matériau pyrotechnique peut être disposé dans la cavité ou dans une cavité additionnelle formée dans le capot de protection, un micro-orifice du capot de protection reliant les deux cavités.

L'invention a également pour objet un procédé de réglage de la pression dans la cavité d'une microstructure comportant la mise à feu d'au moins un élément en matériau pyrotechnique après scellement du capot de protection fermant la cavité.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre schématiquement une microstructure selon l'art antérieur.
La figure 2 représente un premier mode de réalisation d'une microstructure selon l'invention.
Les figures 3 et 4 représentent respectivement un capot et la microstructure sur laquelle est fixé ce capot dans un second mode de réalisation de l'invention.

### Description de modes particuliers de réalisation.

Selon l'invention, la microstructure comporte au moins un élément en matériau pyrotechnique dont la combustion libère du gaz dans la cavité 3 après scellement du capot de protection 4. La quantité de gaz libéré par combustion correspond à la pression désirée à l'intérieur de la cavité.

Dans un premier mode de réalisation, illustré à la figure 2, un élément 6 en matériau pyrotechnique est disposé à l'intérieur de la cavité 3. Le matériau pyrotechnique constituant l'élément 6 peut être déposé sur une résistance électrique 7, formée directement sur le substrat de base 1, à l'intérieur de la cavité 3. La résistance électrique 7 est connectée à des bornes électriques externes 8. Après scellement de la cavité, l'application d'une tension électrique entre les bornes électriques externes 8 provoque l'échauffement de la résistance 7 par effet Joule et la mise à feu de l'élément 6 en matériau pyrotechnique. La combustion de celui-ci provoque le dégagement d'une quantité prédéterminée de gaz, permettant d'amener la pression à l'intérieur de la cavité 3 à une valeur prédéterminée.

La pression peut être générée en plusieurs étapes, à partir d'une multitude d'éléments 6, ou micro-cellules, en matériau pyrotechnique pouvant être mis à feu sélectivement et/ou séquentiellement. Les éléments 6 peuvent comporter des quantités différentes de matériau pyrotechnique, de manière à permettre un réglage plus ou moins fin de la pression dans la cavité. La mise à feu sélective et séquentielle des différents éléments peut être réalisée par tout moyen approprié. Chaque élément 6 peut, notamment, être associé à une résistance électrique 7 correspondante. Un circuit externe de contrôle (non représenté) applique sélectivement une tension aux bornes de l'une des résistances pour la mise à feu de l'élément correspondant.

Dans une variante de réalisation, la mise à feu d'un élément 6 est provoquée par un faisceau laser provenant de l'extérieur de la microstructure et dirigé vers l'élément pyrotechnique à travers une zone du capot 4 transparente à la longueur d'onde du faisceau laser.

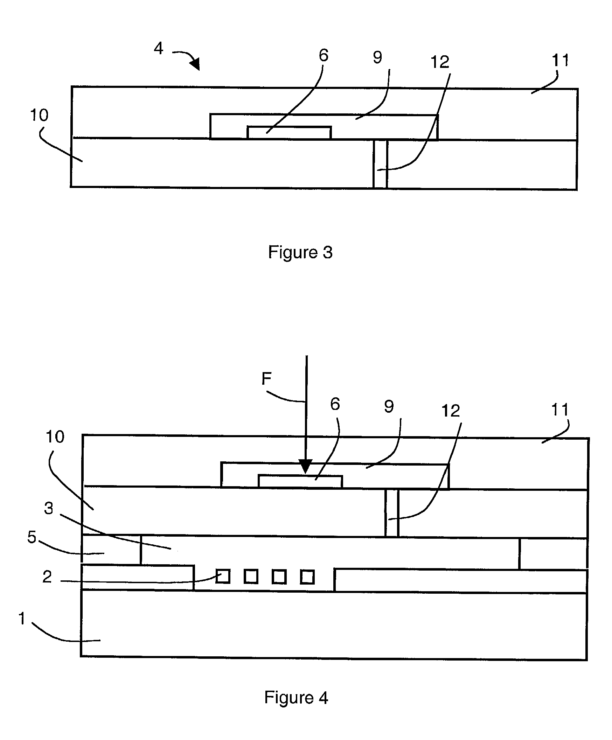

Dans le mode de réalisation illustré aux figures 3 et 4, les éléments 6 ne sont pas disposés directement dans la cavité 3 mais dans une cavité additionnelle 9 formée dans le capot 4. Le capot 4 est, par exemple, constitué par une première partie 10, plane, en silicium, sur laquelle sont disposés les éléments 6 en matériau pyrotechnique. Une seconde partie 11, disposée sur la première partie, comporte un évidement délimitant avec la première partie 10, la cavité additionnelle 9 du capot dans laquelle sont placés les éléments 6. Un micro-orifice 12, formé dans la première partie 10 du capot, relie les cavités 3 et 9 lorsque le capot 4 est mis en place sur la microstructure (figure 4). Le micro-orifice 12 permet le passage dans la cavité 3 du gaz généré par la combustion des éléments 6 tout en retenant les résidus solides éventuellement produits lors de la combustion des éléments 6.

Comme précédemment, la mise à feu des éléments 6 peut être réalisée sélectivement à partir d'un réseau de résistances associées ou au moyen de faisceaux laser (F) provenant de l'extérieur de la microstructure et dirigés sélectivement et/ou séquentiellement vers les élément pyrotechniques sélectionnés à travers une zone du capot 4 transparente à la longueur d'onde des faisceaux laser. La zone du capot 4 qui est transparente à la longueur d'onde des faisceaux laser peut être constituée par du verre constituant la totalité de la seconde partie 11.

Le scellement du capot 4 sur le substrat de base 1, avant réglage de la pression dans la cavité 3, peut être réalisé par tout moyen approprié, notamment par scellement anodique ou eutectique, par soudure avec un alliage d'étain et de plomb (SnPb) ou au moyen d'un cordon de scellement en polymère ou en verre fusible.

Tous les modes de réalisation décrits peuvent être mis en oeuvre par la fabrication collective de plusieurs microstructures selon l'invention, par exemple sur un même plaque de matériau constituant le substrat de base, par exemple en silicium. Le scellement est alors, de préférence, effectué de manière collective, une étape supplémentaire permettant ensuite la découpe des microstructures obtenues sur la plaque de matériau initiale.

Le scellement peut être effectué sous vide, de manière à garantir une bonne propreté de la cavité 3, la pression finale dans la cavité étant ultérieurement déterminée par la mise à feu sélective des éléments 6 en matériau pyrotechnique. Il est également possible d'effectuer le scellement sous une pression non nulle et de n'utiliser la mise à feu des éléments 6 que pour compléter la quantité de gaz nécessaire. Dans un mode de réalisation préférentiel, le scellement étant réalisé à pression atmosphérique, donc peu coûteux, le gaz dégagé par la combustion d'éléments 6 est utilisé essentiellement pour compenser la baisse de pression due au refroidissement après scellement (à titre d'exemple, la pression est divisée environ par deux lors que la température redescend de 300°C à la température ambiante).

Le gaz généré par les éléments 6 en matériau pyrotechnique est, de préférence, un gaz neutre, non corrosif. À titre d'exemple, le matériau pyrotechnique peut être du type de celui utilisé dans les sacs gonflables (« airbags »), qui est constitué par un mélange d'azoture de sodium (NaN₃), de nitrate de potassium (KNO₃) et de silice (SiO₂) et libère de l'azote (N₂) et des résidus solides K₂NaSiO₄. De nombreux autres matériaux pyrotechniques peuvent également être utilisés, permettant de générer d'autres gaz, notamment du monoxyde de carbone (CO), du dioxyde de carbone (CO₂), de la vapeur d'eau (H₂O) ou de l'hydrogène (H₂).

À titre d'exemple, une quantité de gaz de 2mm³ destinée à remplir une cavité 3 de 2mmx2mmx0,5mm peut être libérée par la combustion d'environ 2•10-³_{MM}³ de matériau pyrotechnique. Le matériau pyrotechnique peut, par exemple, être déposé sous la forme d'une micro-pastille de 100µmx100µmx200µm, ce qui est tout à fait compatible avec sa disposition dans une micro-cavité de la microstructure ou du capot.

L'invention peut notamment être utilisée pour le réglage du facteur d'amortissement de microstructures d'un accéléromètre, dont dépendent les résonances parasites et la bande passante. A titre d'exemple, la bande passante d'accéléromètres du type décrit dans les brevets EP149572, EP605300 ou EP605303 de la demanderesse peut être réduite d'un facteur de l'ordre de trois en faisant passer la pression à l'intérieur de la cavité 3 de 0,1bar à 1bar. L'invention permet également de personnaliser individuellement, par réglage de la pression de gaz dans la cavité correspondante, la bande passante d'accéléromètres fabriqués simultanément sur un même substrat de base 1, à partir d'une même filière technologique. Ceci présente un intérêt économique non négligeable, en permettant de répondre simplement et rapidement à des demandes variées. Il est également envisageable de réduire la bande passante d'un accéléromètre en cours de fonctionnement, par mise à feu sélective d'un ou de plusieurs éléments 6 en matériau pyrotechnique, en fonction de la détection de certains événements.

## Revendications

1. Microstructure électromécanique intégrée comportant un substrat de base (1), une cavité (3) fermée par un capot de protection (4), et des éléments mécaniques mobiles (2) disposés dans la cavité (3), ladite microstructure comportant des moyens de réglage de pression comportant au moins un élément (6) en matériau pyrotechnique dont la combustion libère du gaz dans la cavité (3), de manière à régler la pression dans la cavité (3) après scellement du capot de protection (4).

2. Microstructure selon la revendication 1, **caractérisée en ce que** l'élément (6) en matériau pyrotechnique est disposé dans la cavité (3).

3. Microstructure selon la revendication 1, **caractérisée en ce que** l'élément (6) en matériau pyrotechnique est disposé dans une cavité additionnelle (9) formée dans le capot de protection (4), un micro-orifice (12) du capot de protection (4) reliant les deux cavités (3, 9).

4. Microstructure selon l'une quelconque des revendications 1 à 3, **caractérisée en ce que** le matériau pyrotechnique est déposé sur une résistance électrique (7) connectée à des bornes électriques externes (8).

5. Microstructure selon l'une quelconque des revendications 1 à 3, **caractérisée en ce que** le capot de protection (4) comporte une zone en matériau transparent à une longueur d'onde prédéterminée.

6. Microstructure selon l'une quelconque des revendications 1 à 5, **caractérisée en ce que** le matériau pyrotechnique est un mélange d'azoture de sodium, de nitrate de potassium et de silice.

7. Microstructure selon l'une quelconque des revendications 1 à 6, **caractérisée en ce que** les moyens de réglage de pression comportent une pluralité d'éléments (6) en matériau pyrotechnique pouvant être mis à feu sélectivement.

8. Procédé de réglage de la pression dans une cavité (3) comportant des éléments mobiles (2) d'une microstructure, selon l'une quelconque des revendications 1 à 7, ledit procédé comportant, après scellement du capot de protection (4) fermant la cavité (3), la mise à feu de l'élément (6) en matériau pyrotechnique de manière à régler la pression dans la cavité (3) comportant les éléments mobiles (2).

9. Procédé selon la revendication 8 pour le réglage de la pression dans la cavité (3) d'une microstructure selon la revendication 5, **caractérisé en ce que** la mise à feu de l'élément (6) en matériau pyrotechnique est provoquée par un faisceau laser provenant de l'extérieur de la microstructure et dirigé vers l'élément en matériau pyrotechnique à travers une zone transparente du capot de protection (4).

## Patentansprüche

1. Integrierte elektromagnetische Mikrostruktur mit einem Basisträger (1), einem durch eine Schutzhaube (4) verschlossenen Hohlraum (3) sowie beweglichen mechanischen Elementen (2), die in dem Hohlraum (3) angeordnet sind,
wobei die Mikrostruktur Einrichtungen zum Regeln des Drucks enthält, die mindestens ein Element (6) aus einem pyrotechnischen Material enthalten, dessen Verbrennung in dem Hohlraum (3) Gas freisetzt, um den Druck in dem Hohlraum (3) nach dem Verschließen der Schutzhaube (4) zu regeln.

2. Mikrostruktur nach Anspruch 1, **dadurch gekennzeichnet, dass** das Element (6) aus pyrotechnischem Material in dem Hohlraum (3) angeordnet ist.

3. Mikrostruktur nach Anspruch 1, **dadurch gekennzeichnet, dass** das Element (6) aus pyrotechnischem Material in einem zusätzlichen Hohlraum (9) angeordnet ist, der in der Schutzhaube (4) ausgebildet ist, wobei eine Mikroöffnung (12) der Schutzhaube (4) die beiden Hohlräume (3, 9) miteinander verbindet.

4. Mikrostruktur nach einem der Ansprüche 1 bis 3, **dadurch gekennzeichnet, dass** das pyrotechnische Material auf einem elektrischen Widerstand (7) abgelagert ist, der mit externen elektrischen Anschlüssen (8) verbunden ist.

5. Mikrostruktur nach einem der Ansprüche 1 bis 3, **dadurch gekennzeichnet, dass** die Schutzhaube (4) einen Bereich aus transparentem Material mit einer vorgegebenen Wellenlänge aufweist.

6. Mikrostruktur nach einem der Ansprüche 1 bis 5, **dadurch gekennzeichnet, dass** das pyrotechnische Material aus einer Mischung aus Natriumazid, Kaliumnitrat und Kieselsäure besteht.

7. Mikrostruktur nach einem der Ansprüche 1 bis 6, **dadurch gekennzeichnet, dass** die Einrichtungen zum Regeln des Drucks mehrere Elemente (6) aus pyrotechnischem Material aufweisen, welche wahlweise entzündet werden können.

8. Verfahren zur Regelung des Drucks in einem Hohlraum (3) mit beweglichen Elementen (2) einer Mikrostruktur nach einem der Ansprüche 1 bis 7, wobei das Verfahren nach dem Verschließen der Schutzhaube (4), die den Hohlraum (3) verschließt, das Entzünden des Elementes (6) aus pyrotechnischem Material umfasst, um den Druck in dem die beweglichen Elemente (2) enthaltenden Hohlraum (3) zu regeln.

9. Verfahren nach Anspruch 8 zum Regeln des Drucks in dem Hohlraum (3) einer Mikrostruktur nach Anspruch 5, **dadurch gekennzeichnet, dass** das Entzünden des Elementes (6) aus pyrotechnischem Material durch einen Laserstrahl hervorgerufen wird, der von der Außenseite der Mikrostruktur kommt und auf das Element aus pyrotechnischem Material durch einen transparenten Bereich der Schutzhaube (4) hindurch gerichtet ist.

## Claims

1. Integrated electromechanical microstructure comprising a base substrate (1) and a cavity (3) closed by a protective cover (4), and mobile mechanical elements (2) arranged in the cavity (3),
said microstructure comprising pressure adjusting means comprising at least one element (6) made of pyrotechnic material, combustion whereof releases gas into the cavity (3) so as to adjust the pressure in the cavity (3) after the protective cover (4) has been sealed

2. Microstructure according to claim 1, **characterized in that** the element (6) made of pyrotechnic material is arranged in the cavity (3).

3. Microstructure according to claim 1, **characterized in that** the element (6) made of pyrotechnic material is arranged in an additional cavity (9) formed in the protective cover (4), a micro-orifice (12) of the protective cover (4) joining the two cavities (3, 9).

4. Microstructure according to any claim 1 to 3, **characterized in that** the pyrotechnic material is deposited on an electrical resistor (7) connected to external electrical terminals (8).

5. Microstructure according to any claim 1 to 3, **characterized in that** the protective cover (4) comprises a zone made of material transparent at a preset wavelength.

6. Microstructure according to any claim 1 to 5, **characterized in that** the pyrotechnic material is a mixture of sodium nitride, potassium nitrate and silica.

7. Microstructure according to any claim 1 to 6, **characterized in that** the pressure adjusting means comprise a plurality of elements (6) made of pyrotechnic material able to be selectively ignited.

8. Method for adjusting the pressure in a cavity (3) comprising mobile mechanical elements (2) of a microstructure according to any claim 1 to 7, said method comprising ignition of the element (6) made of pyrotechnic material so as to adjust the pressure in a cavity (3) comprising mobile mechanical elements (2).

9. Method according to claim 8 for adjusting the pressure in the cavity (3) of a microstructure according to claim 5, **characterized in that** the ignition of the element (6) made of pyrotechnic material is caused by a laser beam coming from outside the microstructure and directed towards the element made of pyrotechnic material through the transparent zone of the protective cover (4).
